# EUROPÄISCHE PATENTANMELDUNG

(11) **EP 2 169 830 A2**
(43) Veröffentlichungstag der Anmeldung: **31.03.2010**
(21) Anmeldenummer: 09164759.4
(22) Anmeldetag: 07.07.2009
(51) Int. Cl.: H03M 1/08, H03M 1/12

(54) **Vorrichtung zur Umsetzung eines analogen Signals in ein digitales Signal**

(30) Priorität: 26.09.2008 WO PCT/EP2008/008359
(71) Anmelder: Siemens Aktiengesellschaft, 80333 München (DE)
(72) Erfinder: Fischer, Peter, 92421 Schwandorf (DE)

(57) **Zusammenfassung**

Die Erfindung bezieht sich auf eine Vorrichtung (1) zur Umsetzung eines analogen Signals in ein digitales Signal umfassend,
- einen Analog/Digital-Wandler (2),
- einen Eingang (3) für ein analoges Signal,
**gekennzeichnet durch,**
ein Mikroelektromechanisches System (MEMS) zum Erfassen des analogen Signals, wobei
- eine Mess-Spule (L) und
- ein mikroelektromechanischer Oszillator zum Bewegen der Mess-Spule (L) derart Zusammenwirken, dass bei Bewegung der Mess-Spule (L) in dem durch das analoge Signal, bewirkten Magnetfeld (B) eine zyklische Änderung des die Mess-Spule (L) durchsetzenden magnetischen Flusses bewirkt wird,
wobei das Mikroelektromechanisches System (MEMS) zum Erfassen einer in der Mess-Spule (L) aufgrund der Änderung des die Mess-Spule (L) durchsetzenden magnetischen Flusses induzierten Spannung als Messgröße des analogen Signals ausgebildet ist.

## Beschreibung

Die Erfindung betrifft eine Vorrichtung zur Umsetzung eines analogen Signals in ein digitales Signal umfassend, einen Analog/Digital-Wandler, einen Eingang für ein analoges Signal.

Mit einem Analog/Digital-Wandler wird ein analoger, vorzugsweise stetiger Wertebereich auf einen diskreten Zahlenbereich abgebildet. Bei derartigen A/D- und D/A-Wandlern sind eine Analogseite und eine Digitalseite jeweils auf unterschiedliche Referenzpotentiale bezogen, so dass Potentialunterschiede auftreten können. Diese müssen auf geeignete Weise kompensiert werden.

Dies geschieht bisher dadurch, dass die Digitalseite durch diskrete Bauteile von der Analogseite potentialgetrennt ist.

Aus der EP 1 052 780 A2 ist bereits ein A/D- oder D/A-Wandler mit galvanischer Trennung bekannt, wobei zur Trennung ein magnetosensitives Koppelelement eingesetzt wird.

Des Weiteren sind auch mikroelektromechanische Systeme (Micro-Elektro-Mechanical Systems, MEMS) bekannt. Diese werden häufig auch als Mikrosysteme bezeichnet und finden in unterschiedlichen Anwendungsbereichen, wie beispielsweise als Beschleunigungs- und Neigungssensoren, Drehratensensoren oder Drucksensoren, zunehmende Verbreitung.

Der vorliegenden Erfindung liegt die Aufgabe zugrunde, eine bekannte Vorrichtung zur Umsetzung eines analogen Signals in ein digitales Signal zu verbessern und leistungsfähiger auszugestalten.

Die Aufgabe wird dadurch gelöst, dass die eingangs genannte Vorrichtung ein mikro-elektro-mechanisches System zum Erfassen des analogen Signals aufweist, wobei eine Mess-Spule und ein mikro-elektro-mechanischer Oszillator zum Bewegen der Mess-Spule derart zusammenwirken, dass bei Bewegung der Mess-Spule in dem durch das analoge Signal, bewirkten Magnetfeld eine zyklische Änderung des die Mess-Spule durchsetzenden magnetischen Flusses bewirkt wird, wobei das mikro-elektro-mechanische System zum Erfassen einer in der Mess-Spule aufgrund der Änderung des die Mess-Spule durchsetzenden magnetischen Flusses induzierten Spannung als Messgröße des analogen Signals ausgebildet ist.

Vorteilhafter Weise macht sich die Vorrichtung mit dem mikro-elektro-mechanischen System ein induktives Prinzip zunutze, um das analoge Signal als Messgröße zu erfassen. Hierzu wird eine Mess-Spule in den durch den elektrischen Strom des analogen Signals bewirkten, einen elektrischen Leiter umgebenen Magnetfeld mittels eines mikro-elektro-mechanischen bzw. mikromechanischen Oszillators bewegt.

Von besonderem Vorteil ist es, wenn das mikro-elektro-mechanische System zwischen dem Eingang und dem Analog/DigitalWandler zur Potentialtrennung eines analogen Signalpfades von einem digitalen Signalpfad angeordnet ist. Vorteilhaft hieran ist es, dass eine galvanisch getrennte Erfassung einer Messgröße des analogen Signals mittels des mikro-elektro-mechanischen Systems ermöglicht wird. Eine derartige galvanische Trennung weist in Abhängigkeit von dem jeweiligen Anwendungsfall üblicherweise Weise insbesondere Vorteile hinsichtlich der Sicherheit, der Messgenauigkeit sowie der Verhinderung von Brummschleifen und elektromechanischen Störungen auf. Darüber hinaus ist es von Vorteil, dass der zu messende bzw. zu erfassende elektrische Strom nicht durch das mikro-elektro-mechanische System selbst fließt. Dadurch, dass aus der induktiv erfassten Messgröße in Form der induzierten Spannung eine Bestimmung des in dem elektrischen Leiter fließenden elektrischen Stroms unter Einhaltung eines Isolationsabstandes zu dem elektrischen Leiter möglich ist, wird eine Beeinträchtigung des mikro-elektro-mechanischen Systems durch den in dem elektrischen Leiter fließenden elektrischen Strom zuverlässig vermieden. Dies gilt insbesondere im Hinblick auf hohe Stromstärken. Dabei ist es vorteilhaft, dass auf eine Überspannungs-Schutzschaltung, welche üblicherweise durch Dioden ausgebildet ist und am Eingang der Vorrichtung angeordnet ist, verzichtet werden kann und somit keine zusätzlichen externen elektronischen Bauteile erforderlich sind und dadurch weniger Platz erforderlich ist.

Eine weitere Platzersparnis wird erzielt, wenn das mikro-elektro-mechanische System und der Analog/Digital-Wandler als eine integrierte Schaltung ausgestaltet sind.

In einer besonders bevorzugten Weiterbildung ist das mikro-elektro-mechanische System zum bestimmen des durch einen elektrischen Leiter im analogen Signalpfad fließenden Stromes aus der erfassten induzierten Spannung ausgebildet. Dabei ist das mikro-elektro-mechanische System bevorzugt derart ausgestaltet, dass der elektrische Leiter einen Hin- und einen Rückleiter aufweist und der mikro-elektro-mechanische Oszillator zum Bewegen der Mess-Spule zwischen dem Hin- und dem Rückleiter des elektrischen Leiters ausgebildet ist.

Weiterhin ist es vorteilhaft, wenn ein mikro-elektro-mechanischer kapazitiver Spannungsmesser zum Erfassen der Spannung des elektrischen Leiters vorgesehen ist. Dabei kann der Spannungsmesser mechanisch an den mikro-elektro-mechanischen Oszillator angekoppelt sein.

Weitere Vorteile und Merkmale werden anhand der Zeichnung erläutert. Es zeigen:
- FIG 1: ein Ausführungsbeispiel einer Vorrichtung zur Umsetzung eines analogen Signals in ein digitales Signal,
- FIG 2: eine schematische Skizze zur Verdeutlichung der Funktionsweise eines mikro-elektro-mechanischen Systems, MEMS-Voltmeter,
- FIG 3: eine weitere schematische Skizze zur weiteren Verdeutlichung des mikro-elektro-mechanischen Systems und
- FIG 4: ein Ausführungsbeispiel eines mikro-elektro-mechanischen Systems.

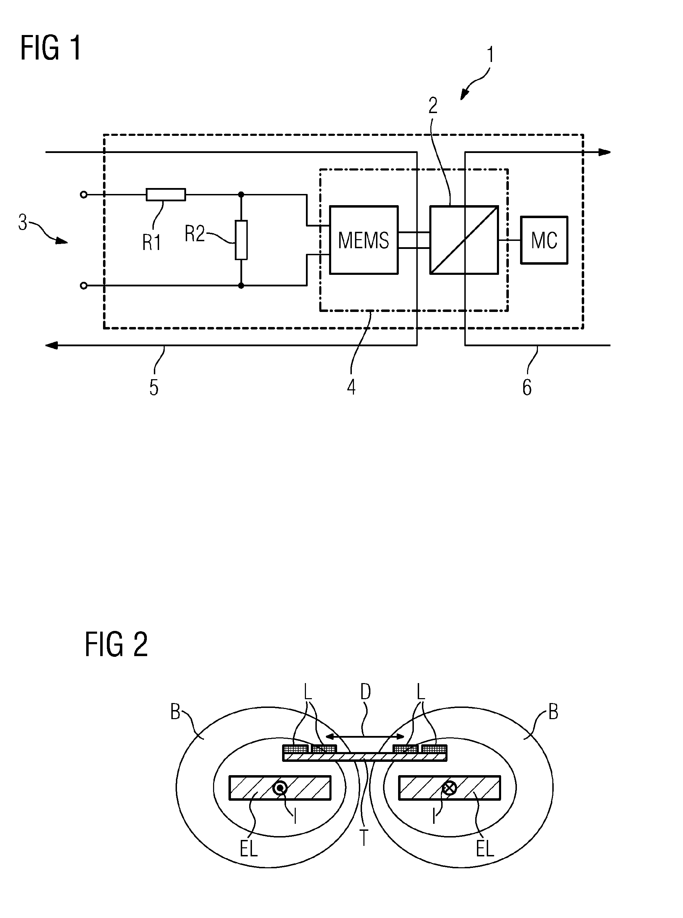

Gemäß der FIG 1 ist eine Vorrichtung 1 zur Umsetzung eines analogen Signals in ein digitales Signal dargestellt, wobei über einen Eingang 3 das analoge Signal mittels eines Spannungsteilers, gebildet aus einem ersten Widerstand R1 und einem zweiten Widerstand R2, an ein mikro-elektro-mechanisches System MEMS angeschaltet ist. Ein in das mikro-elektro-mechanische System MEMS geführter Leiter führt einen Strom, welcher eine Messgröße bzw. das analoge Signal repräsentiert. In einer Reihenschaltung zu dem Leiter ist innerhalb des Systems MEMS ein Messwiderstand angeordnet, welcher auf den Spannungsteilen abgestimmt ist.

Das analoge Signal, welches über einen analogen Signalpfad geführt wird, kann die Vorrichtung 1 bis zu einem Ort der galvanischen Trennung durchlaufen. Die galvanische Trennung wird dabei durch das mikro-elektro-mechanische System MEMS realisiert. An das mikro-elektro-mechanische System MEMS ist ein Analog/Digital-Wandler 2 angeschaltet, wobei sich durch den Analog/Digital-Wandler 2 ein digitaler Signalpfad 6 zieht, welcher letztendlich einen Mikrocontroller µc mit den digitalisierten Daten des umgesetzten bzw. gewandelten analogen Signals versorgt.

Durch die Verwendung eines mikro-elektro-mechanischen Systems MEMS, im Folgenden MEMS-Voltmeter genannt, ist bei dem Einsatz der Vorrichtung 1 zum Wandeln des analogen Signals in ein digitales Signal ein Überspannungsschutz am Anfang des analogen Signalpfades 5 nicht mehr notwendig. Auf zusätzliche elektronische Schutzbauteile kann somit vorteilhaft verzichtet werden. Weiterhin ist es von Vorteil, dass eine Hilfsspannung für den A/D-Wandler, wie es bei Analog/Digital-Wandlungsvorrichtungen nach dem Stand der Technik erforderlich ist, verzichtet werden kann. Aufgrund der Potentialtrennung im analogen Signalpfad 5 ist eine Zusatzschaltung, beispielsweise DC-DC-Wandler, nicht mehr erforderlich.

Die notwendige Spannungsversorgung für den A/D-Wandler kann mit Vorteil von der Seite des digitalen Signalpfades 6 entnommen werden, dies macht eine Verlagerung der Potentialtrennung auf die Seite des analogen Signalpfades möglich.

Durch das MEMS-Voltmeter wird eine galvanische Trennung bzw. eine Potentialtrennung vor dem Analog/Digital-Wandler 2 erreicht. Damit ist eine Potentialtrennung im analogen Signalpfad 5 erreicht. Durch die Potentialtrennung im analogen Signalpfad 5 können zusätzlich mehrere Kanäle unterschiedlicher Potentiale über einem Multiplexer an einen A/D-Wandler geführt werden und die Kosten einer Gesamtschaltung verringert werden.

FIG 2 zeigt eine schematische Skizze zur Verdeutlichung der Funktionsweise eines mikro-elektro-mechanisches Systems, MEMS-Voltmeter.

Dargestellt ist ein Querschnitt senkrecht zur Verlaufsrichtung eines elektrischen Leiters EL, der aus einem Hin- und einem Rückleiter besteht. In dem elektrischen Leiter EL fließt ein elektrischer Strom I, dessen Stromrichtung in üblicher Art und Weise angedeutet ist. Aufgrund des in dem elektrischen Leiter EL fließenden Stromes I bildet sich um den elektrischen Leiter EL ein Magnetfeld B aus.

Um nun mittels eines mikroelektromechanischen Systems eine Messgröße für den durch den elektrischen Leiter EL fließenden Strom I erfassen beziehungsweise diesen Strom I quantitativ messen zu können, ist eine Mess-Spule L vorgesehen, die in dem dargestellten Ausführungsbeispiel zwei Windungen aufweist und in flacher Form ausgebildet ist. Die Mess-Spule L ist auf einem Träger T angebracht, der mittels eines aus Gründen der Übersichtlichkeit nicht dargestellten mikromechanischen beziehungsweise mikroelektromechanischen Oszillators derart bewegt wird, dass eine zyklische Änderung des die Mess-Spule L durchsetzenden magnetischen Flusses bewirkt wird. In dem beschriebenen Ausführungsbeispiel erfolgt hierbei ein Schwingen des mikroelektromechanischen Oszillators und damit auch der mit dem Träger T verbundenen Mess-Spule L in der durch den Doppelpfeil angedeuteten Bewegungsrichtung D, d.h. senkrecht zum Verlauf des elektrischen Leiters EL. Aufgrund der durch die Bewegung der Mess-Spule L in dem Magnetfeld B des elektrischen Leiters EL bewirkten Änderung des die Mess-Spule L durchsetzenden magnetischen Flusses wird in der Mess-Spule L eine Spannung induziert, die zu dem durch den elektrischen Leiter EL fließenden elektrischen Strom I proportional ist und damit eine Messgröße für diesen darstellt.

Es sei darauf hingewiesen, dass die Mess-Spule L abweichend von der Darstellung der FIG 2 selbstverständlich auch in einem Magnetfeld eines einzelnen elektrischen Leiters, d.h. nicht zwischen einem Hin- und einem Rückleiter, bewegt werden könnte. Ausgehend von der Darstellung der FIG 2 könnte dies beispielsweise so aussehen, dass der linke Teil des elektrischen Leiters EL in der Darstellung entfällt und der Träger T mit der Mess-Spule L nach rechts verschoben wird, so dass die Mess-Spule L um die Mitte des dann nur einen Leiter aufweisenden elektrischen Leiters EL schwingt. Auch in diesem Fall ergibt sich eine Änderung des die Mess-Spule L durchsetzenden magnetischen Flusses, so dass auch mittels einer solchen Anordnung eine Messgröße für den durch den elektrischen Leiter EL fließenden Strom I erfassbar ist. Die in der FIG 2 dargestellte Ausführungsform weist jedoch den Vorteil auf, dass aufgrund dessen, dass die Mess-Spule L zwischen dem Hin- und dem Rückleiter des elektrischen Leiters EL bewegt wird, die in der Mess-Spule L induzierte Spannung eine größere Amplitude aufweist. Ursache hierfür ist, dass mittels der Bewegung der Mess-Spule L zwischen dem Hin- und dem Rückleiter eine besonders starke Änderung des die Mess-Spule L durchsetzenden magnetischen Flusses bewirkt wird.

Um eine möglichst große induzierte Spannung zu erzielen beziehungsweise den Isolationsabstand zwischen der Mess-Spule L und dem elektrischen Leiter EL erforderlichenfalls vergrößern zu können, ist es weiterhin möglich, die Anzahl der Windungen beziehungsweise die Fläche der Mess-Spule L zu erhöhen beziehungsweise zu vergrößern und/oder die Amplitude der durch den mikroelektromechanischen Oszillator bewirkten Bewegung möglichst groß zu wählen.

Hinsichtlich ihrer Dimensionierung könnte die in FIG 2 dargestellte Anordnung beispielsweise so ausgelegt werden, dass bei einem elektrischen Leiter EL mit einer Breite von 2mm der Abstand zwischen der Mess-Spule L und der Oberfläche des elektrischen Leiters EL einen halben Millimeter beträgt. Dem entsprechend könnte die Mess-Spule L in der Darstellung der FIG 2 eine horizontale Ausdehnung in der Größenordnung von 1mm aufweisen und die Amplitude der durch den mikroelektromechanischen Oszillator bewirkten zyklischen Bewegung beispielsweise einen halben Millimeter betragen. Es sei jedoch nachdrücklich darauf hingewiesen, dass es sich bei den genannten Werten lediglich um Beispiele handelt und in Abhängigkeit von den jeweiligen Anforderungen sowie dem jeweiligen Anwendungszweck auch Anordnungen mit hiervon gegebenenfalls deutlich abweichenden Werten denkbar sind.

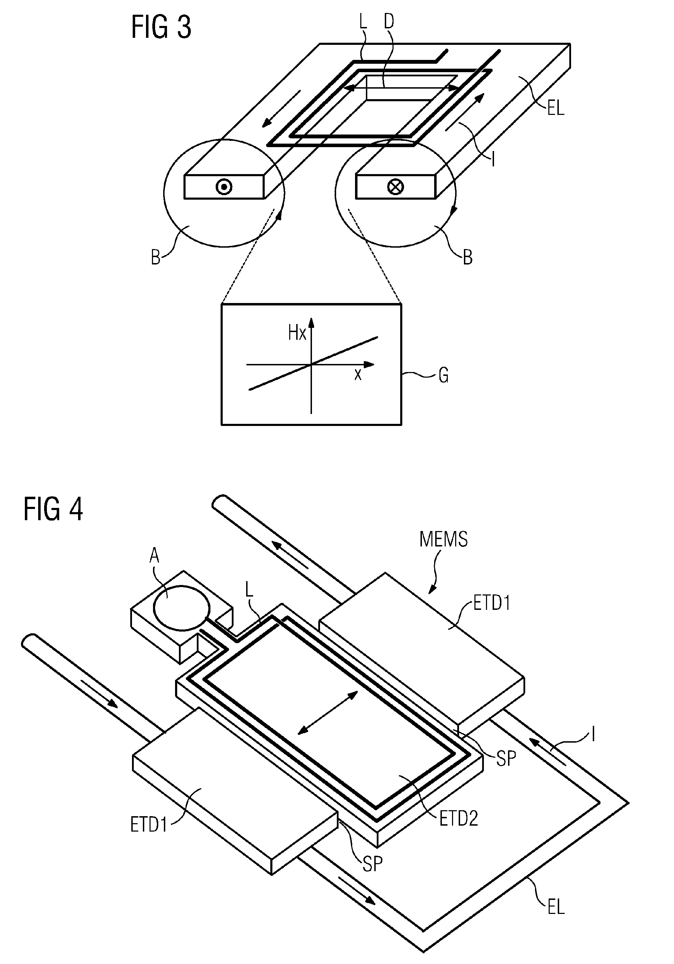

FIG 3 zeigt eine weitere schematische Skizze zur weiteren Verdeutlichung des mikro-elektro-mechanisches Systems. Gezeigt ist hierbei eine perspektivische Darstellung einer im Wesentlichen der FIG 2 entsprechenden Anordnung, wobei zur besseren Veranschaulichung der Träger der Mess-Spule L weggelassen wurde. Erkennbar ist, dass die Mess-Spule L zwischen einem Hin- und einem Rückleiter in Form der Schenkel eines U-förmig ausgebildeten elektrischen Leiters EL bewegt wird, wobei die Bewegungsrichtung D wiederum durch einen entsprechenden Pfeil angedeutet ist. Die sich bei einem durch den elektrischen Leiter EL fließenden Strom I und dem durch diesen Strom I verursachten Magnetfeld in Bewegungsrichtung D ergebende Komponente des Magnetfeldes B ist als Hx bezeichnet als Funktion der Position x in Bewegungsrichtung D in dem Graphen G skizziert. Erkennbar ist, dass sich das Magnetfeld Hx in der Bewegungsrichtung D ändert, so dass sich bei einer Bewegung der Mess-Spule L in der Bewegungsrichtung D eine Änderung des die Mess-Spule L durchsetzende magnetischen Flusses ergibt. Hierdurch wird in der Mess-Spule L eine Spannung induziert, die eine Messgröße für den durch den elektrischen Leiter EL fließenden Strom I darstellt.

Um eine möglichst große Signalamplitude der induzierten Spannung zu erzielen, wird die Schwingungsfrequenz des mikroelektromechanischen Oszillators vorzugsweise im Bereich einiger Kilohertz bis in dem Megahertz Bereich gewählt werden. Dabei ist zu beachten, dass die Schwingungsfrequenz des mikroelektromechanischen Oszillators vorzugsweise derart gewählt wird, dass die spektralen Anteile des elektrischen Stromes I im Bereich der Betriebsfrequenz des mikroelektromechanischen Oszillators vernachlässigt werden können. Hierzu wird vorteilhafter Weise eine Bandpassfilterung mit geringer Bandbreite vorgesehen und die Betriebsfrequenz des mikroelektromechanischen Oszillators deutlich größer, d.h. beispielsweise um einen Faktor 10 bis 100 größer, gewählt als die im Spektrum des elektrischen Stromes I mit signifikanter Amplitude auftretenden maximalen Frequenzen. Dies bedeutet, dass sofern kein Gleichstrom sondern ein elektrischer Wechselstrom mit einer Frequenz von beispielsweise 1 kHz erfasst werden soll, hierfür vorzugsweise ein mikroelektromechanischer Oszillator verwendet wird, dessen Betriebsfrequenz im Bereich von zumindest 10 kHz liegt.

FIG 4 zeigt ein Ausführungsbeispiel eines mikroelektromechanischen Systems als Messgerät. Dargestellt ist ein mikroelektromechanisches System MEMS, das aus einem Anker A, einer Mess-Spule L, zwei ersten Elektroden ETD1 sowie einer zweiten Elektrode ETD2 besteht. Darüber hinaus ist in der in FIG 4 gezeigten Anordnung neben dem mikroelektromechanischen System MEMS ein U-förmiger elektrischer Leiter EL dargestellt. An dieser Stelle sei generell darauf hingewiesen, dass der elektrische Leiter EL grundsätzlich auch Bestandteil der eigentlichen Messvorrichtung sein kann. In diesem Fall wird ein zu messender Strom somit in den elektrischen Leiter EL eingeleitet, der in diesem Fall in der Messvorrichtung üblicherweise mit einem festen Abstand zum mikroelektromechanischen System MEMS angeordnet sein wird. Alternativ hierzu kann jedoch der elektrische Leiter EL auch Bestandteil einer beliebigen anderen Komponente sein, in welchem Fall die eigentliche Messvorrichtung den elektrischen Leiter EL somit nicht mit umfasst.

Bei dem in FIG 4 dargestellten mikroelektromechanischen System MEMS wird durch den Anker A sowie die ersten Elektroden ETD1 und die zweite Elektrode ETD2 ein mikroelektromechanischer Oszillator gebildet. Dabei ist der schwingfähige Teil des Oszillators, der durch die zweite Elektrode ETD2 gegeben ist, an dem Anker A aufgehängt. Zwischen der zweiten Elektrode ETD2 und den jeweiligen ersten Elektroden ETD1 befindet sich jeweils ein Luftspalt SP, dessen Breite üblicherweise im Mikrometerbereich liegen wird. Durch ein zyklisches Anlegen entsprechender Potenziale auf den Elektroden ETD1, ETD2 wird aufgrund wirkender elektrostatischer Kräfte ein mechanisches Schwingen der zweiten Elektrode ETD2 bewirkt, wobei die Bewegungsrichtung in FIG 4 durch den dargestellten Doppelpfeil angedeutet ist. Entsprechend der Darstellung ist eine Mess-Spule L, die in dem dargestellten Beispiel wiederum zwei Windungen aufweist, auf der zweiten Elektrode ETD2 befestigt, so dass mittels des mikroelektromechanischen Oszillators die Mess-Spule L derart bewegt wird, dass aufgrund der Bewegung der Mess-Spule L in dem durch den elektrischen Strom I bewirkten Magnetfeld des elektrischen Leiters EL eine zyklische Änderung des die Mess-Spule L durchsetzenden magnetischen Flusses bewirkt wird. Hierdurch wird, wie zuvor bereits erläutert, eine Spannung in der Mess-Spule L induziert, die durch entsprechende Mittel erfasst werden und aus der der in dem elektrischen Leiter EL fließende Strom I ermittelt werden kann.

Es sei darauf hingewiesen, dass im Rahmen des mikroelektromechanischen Systems selbstverständlich auch mikroelektromechanische Oszillatoren verwendet werden können, die nach einem anderen als einem elektrostatischen Prinzip arbeiten. Darüber hinaus sei vorsorglich darauf hingewiesen, dass selbstverständlich auch eine Mess-Spule mit nur einer oder auch mehr als zwei Windungen verwendet werden kann.

Vorzugsweise kann das in FIG 4 dargestellte mikroelektromechanische System zusätzlich einen kapazitiven Spannungsmesser zum Erfassen der Spannung des elektrischen Leiters EL aufweisen. Ein entsprechendes mikroelektromechanisches System zur kapazitiven Spannungsmessung ist beispielsweise aus der zuvor bereits erwähnten WO 2005/121819 A1 bekannt. Vorzugsweise ist der Spannungsmesser hierbei an den mikroelektromechanischen Oszillator angekoppelt, so dass die durch den Oszillator bewirkte Bewegung nicht nur die Änderung des die Mess-Spule durchsetzenden magnetischen Flusses, sondern darüber hinaus auch eine im Rahmen der Spannungsmessung erforderliche Kapazitätsänderung bewirkt. Hierdurch wird vorteilhafterweise auf besonders einfache, kompakte und kostengünstige Art und Weise ein mikroelektromechanisches System zur Leistungsmessung, d.h. ein Wattmeter, bereitgestellt.

Entsprechend den vorstehend beschriebenen Ausführungsbeispielen weisen das mikroelektromechanische System insbesondere den Vorteil auf, dass auf vergleichsweise einfache Art und Weise eine galvanisch getrennte sowie vielseitig einsetzbare Erfassung einer Messgröße für den durch den elektrischen Leiter fließenden Strom ermöglicht wird. Insbesondere dadurch, dass hierbei der zu messende, durch den elektrischen Leiter fließende elektrische Strom nicht selbst durch das mikroelektromechanische System zu fließen braucht, sind das mikroelektromechanische System sowie das Verfahren darüber hinaus, insbesondere auch hinsichtlich ihrer Anwendbarkeit bei vergleichsweise hohen Stromstärken, vorteilhafterweise besonders leistungsfähig.

## Patentansprüche

1. Vorrichtung (1) zur Umsetzung eines analogen Signals in ein digitales Signal umfassend,
- einen Analog/Digital-Wandler (2),
- einen Eingang (3) für ein analoges Signal,
**gekennzeichnet durch,**
ein Mikroelektromechanisches System (MEMS) zum Erfassen des analogen Signals, wobei
- eine Mess-Spule (L) und
- ein mikroelektromechanischer Oszillator zum Bewegen der Mess-Spule (L) derart Zusammenwirken, dass bei Bewegung der Mess-Spule (L) in dem **durch** das analoge Signal, bewirkten Magnetfeld (B) eine zyklische Änderung des die Mess-Spule (L) durchsetzenden magnetischen Flusses bewirkt wird,
wobei das Mikroelektromechanisches System (MEMS) zum Erfassen einer in der Mess-Spule (L) aufgrund der Änderung des die Mess-Spule (L) durchsetzenden magnetischen Flusses induzierten Spannung als Messgröße des analogen Signals ausgebildet ist.

2. Vorrichtung (1) nach Anspruch 1, wobei das mikroelektromechanische System (MEMS) zwischen dem Eingang (3) und dem Analog/Digital-Wandler (2) zur Potentialtrennung eines analogen Signalpfads (5) von einem digitalen Signalpfad (6) angeordnet ist.

3. Vorrichtung (1) nach Anspruch 1 oder 2, wobei das Mikroelektromechanisches System (MEMS) und der Analog/DigitalWandler (2) als eine integrierte Schaltung (4) ausgestaltet sind.

4. Vorrichtung (1) nach einem der Ansprüche 1 bis 3, wobei das Mikroelektromechanisches System (MEMS) zum Bestimmen des durch einen elektrischen Leiter (EL) im analogen Signalpfad (5) fließenden Stroms (I) aus der erfassten induzierten Spannung ausgebildet ist.

5. Vorrichtung (1) nach einem der Ansprüche 1 bis 4,
wobei ein mikroelektromechanischer kapazitiver Spannungsmesser zum Erfassen der Spannung des elektrischen Leiters (EL) vorgesehen ist.

6. Vorrichtung (1) nach Anspruch 5,
wobei der Spannungsmesser mechanisch an den mikroelektromechanischen Oszillator angekoppelt ist.
